**Europäisches Patentamt**

**European Patent Office**

**Office européen des brevets**

(19)

(11) Veröffentlichungsnummer: **0 176 762**
**B1**

(12) **EUROPÄISCHE PATENTSCHRIFT**

(45) Veröffentlichungstag der Patentschrift:
03.01.90

(51) Int. Cl.⁴: **H01L 27/08**

(21) Anmeldenummer: 85110777.1

(22) Anmeldetag: 27.08.85

(54) **Monolithisch integrierte bipolare Darlington-Schaltung.**

(30) Priorität: 27.09.84 DE 3435571

(43) Veröffentlichungstag der Anmeldung:
09.04.86 Patentblatt 86/15

(45) Bekanntmachung des Hinweises auf die Patenterteilung:
03.01.90 Patentblatt 90/1

(84) Benannte Vertragsstaaten:
**DE FR GB IT NL SE**

(56) Entgegenhaltungen:
**EP-A- 0 089 527**
**EP-A- 0 091 624**
**DE-A- 3 324 476**
**GB-A- 2 100 513**
**US-A- 4 138 690**

(73) Patentinhaber: **Siemens Aktiengesellschaft,**
**Wittelsbacherplatz 2, D-8000 München 2(DE)**

(72) Erfinder: **Herberg, Helmut, Dr. Dipl.-Phys.,**
**Bruderhofstrasse 30a, D-8000 München 70(DE)**

**Beschreibung**

Die Erfindung bezieht sich auf eine monolithisch integrierte bipolare Darlington-Schaltung nach dem Oberbegriff des Patentanspruchs 1.

Eine solche Schaltung ist z.B. aus dem Aufsatz "Power Bipolar Devices" von Ph. Leturcq in der Zeitschrift "Microelectronic Reliab., Bd. 24, No. 2, 1984, S. 313-337, insbesondere Fig. 16 auf S. 333, bekannt.

Im Schaltbetrieb wird hierbei in Abhängigkeit vom Einschalten eines Basisstroms, der von einer zwischen den Basisanschluß und den Emitteranschluß geschalteten Basisstromquelle erzeugt wird, ein Kollektorstrom eingeschaltet, der in einem an den Emitter und den Kollektoranschluß geschalteten äußeren Laststromkreis fließt. Als wichtige Parameter beim Einschalten des Kollektorstroms sind die Einschaltverzögerungszeit $t_d$ und die Anstiegszeit $t_r$ des Kollektorstromes anzusehen. Dabei ist $t_d$ als die Zeitspanne definiert, die zwischen dem Zeitpunkt liegt, an dem der Basisstrom 10 % seines Maximalwertes erreicht, und dem Zeitpunkt, in dem der Kollektorstrom 10 % seines Endwertes erreicht. $t_r$ ist die Zeitspanne, die für den Anstieg des Kollektorstromes von 10 % auf 90 % seines Endwertes benötigt wird. Wird nun zum Zwecke des Abschaltens des Kollektorstromes der Basisstrom in seiner Richtung umgekehrt, so beginnt der Kollektorstrom nach einer sog. Speicherzeit $t_s$ ebenfalls zu sinken, wobei sich eine Fallzeit $t_f$ anschließt, in der der Kollektorstrom von 90 % auf 10 % seines Endwertes absinkt.

Bei Hochvoltanwendungen kann beispielsweise im gesperrten Zustand der Darlington-Schaltung eine Kollektorspannung von 1000 Volt oder mehr zwischen dem Emitter und dem Kollektoranschluß liegen, während im leitenden Zustand ein Kollektorstrom von z.B. 100 A im Laststromkreis fließt, wobei eine Restspannung von z.B. 2 Volt zwischen dem Emitteranschluß und dem Kollektoranschluß des Ausgangstransistors abfällt.

Der Erfindung liegt die Aufgabe zugrunde, eine Darlington-Schaltung der eingangs genannten Art anzugeben, bei der das Schaltverhalten gegenüber herkömmlichen Schaltungen dieser Art verbessert ist. Das wird erfindungsgemäß durch ihre Ausbildung nach dem kennzeichnenden Teil des Patentanspruchs 1 erreicht.

Der mit der Erfindung erzielbare Vorteil liegt insbesondere in einer wesentlichen Verkleinerung der Einschaltverzögerungszeit $t_d$ und der Speicherzeit $t_s$, so daß eine Erhöhung der Schaltgeschwindigkeit beim Ein- und Ausschalten des Kollektorstromes eintritt.

Die Ansprüche 2 bis 10 betreffen bevorzugte Ausgestaltungen und Weiterbildungen der Erfindung.

Die Erfindung wird nachfolgend anhand der Zeichnung näher erläutert. Dabei zeigen:

Fig. 1 ein erstes Ausführungsbeispiel der Erfindung,

Fig. 2 ein zweites Ausführungsbeispiel und die

Figuren 3 bis 5 zweckmäßige Weiterbildungen der Erfindung.

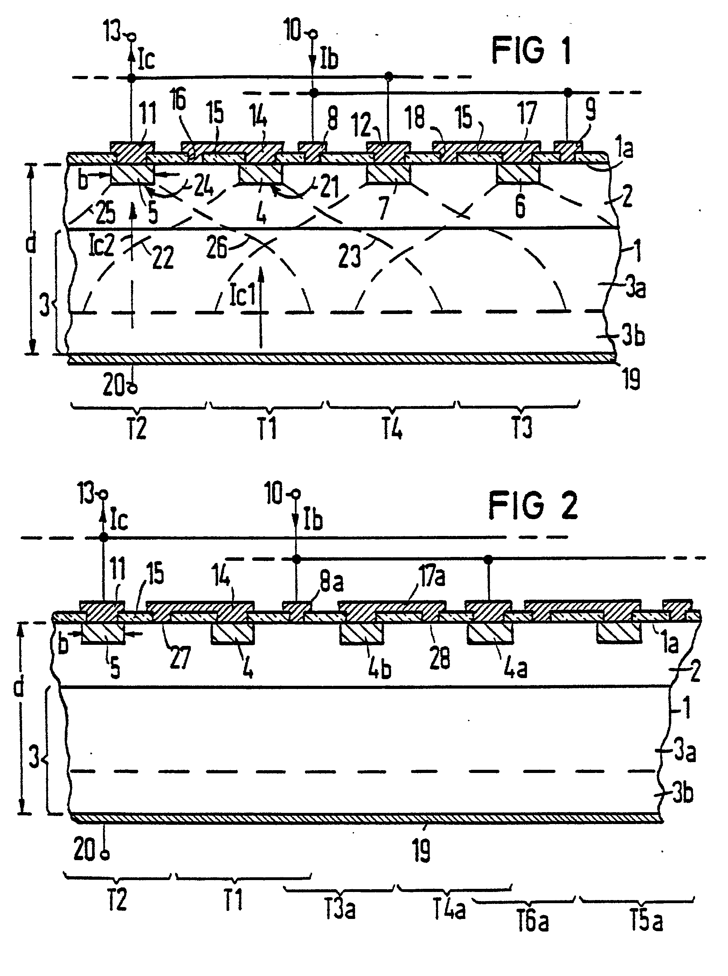

In Fig. 1 ist ein Teil eines scheibenförmigen Körpers 1 aus dotiertem Halbleitermaterial, z.B. Silizium, im Querschnitt dargestellt. Er enthält eine p-leitende Schicht 2, die sich bis zur Grenzfläche 1a von 1 erstreckt, und eine unter dieser angeordnete n-leitende Schicht 3, die aus einer n⁻-dotierten Teilschicht 3a und einer unterhalb derselben liegenden n⁺-dotierten Teilschicht 3b besteht. Für die Teilschichten 3a und 3b können z.B. folgende Dotierungskonzentrationen n vorgesehen sein: $n_{3a} = 1 \cdot 10^{14} cm^{-3}$, $n_{3b} = 2 \cdot 10^{18} cm^{-3}$. Die Schicht 2 stellt eine gemeinsame Basisschicht für bipolare npn-Transistoren T1 bis T4 dar, die Schicht 3 eine diesen gemeinsame Kollektorschicht. In die Basisschicht 2 sind n-leitende, sich jeweils bis zur Grenzfläche 1a erstreckende Emittergebiete 4 bis 7 eingefügt, die den Transistoren T1 bis T4 individuell zugeordnet sind und beispielsweise eine eine Dotierungskonzentration von $n = 5 \cdot 10^{20} cm^{-3}$ (Randkonzentration an der Grenzfläche 1a) aufweisen. Die Schicht 2 hat beispielsweise an der Grenzfläche zum Emittergebiet 4 eine Dotierungskonzentration von $10^{17} cm^{-3}$. Die Transistoren T1 und T3 sind jeweils mit Basiskontakten 8 und 9 versehen, die mit einem Basisanschluß 10 verbunden sind, während die Emittergebiete 5 und 7 der Transistoren T2 und T4 mit Emitterkontakten 11 und 12 belegt sind, die mit einem Emitteranschluß 13 verbunden sind. Das Emittergebiet 4 von T1 ist mit einer leitenden Belegung 14 versehen, die oberhalb einer die Grenzfläche 1a abdeckenden, elektrisch isolierenden Schicht 15, z.B. aus SiO₂, soweit verlängert ist, daß sie die Basisschicht 2 im Bereich eines Fensters 16 der Schicht 15 kontaktiert. Das Fenster 16 ist dabei zwischen den Emittergebieten 4 und 5 angeordnet. In analoger Weise ist das Emittergebiet 6 von T3 mit einer leitenden Belegung 17 versehen, die die Basisschicht 2 durch ein Fenster 18 der isolierenden Schicht 15 zwischen den Emittergebieten 6 und 7 kontaktiert. Die gemeinsame Kollektorshicht 3 ist mit einem Kollektorkontakt 19 versehen, der an einen Kollektoranschluß 20 geführt ist.

Der Halbleiterkörper 1 in Fig. 1 enthält noch weitere, im einzelnen nicht dargestellte Transistorkombinationen T5, T6 bis T(2n-1) T2n, die entsprechend der Kombination T1, T2 oder T3, T4 aufgebaut und in analoger Weise mit den Anschlüssen 10, 13 und 20 verbunden sind. Diese weiteren Kombinationen sind links und rechts von T1, T2 und T3, T4 auf nicht mehr dargestellten Teilen des Halbleiterkörpers 1 angeordnet. Dabei bilden die Transistoren T1, T3, T5 ... T(2n-1) in ihrer Gesamtheit den Treibertransistor und die Transistoren T2, T4, T6 ... Tn2 in ihrer Gesamtheit den Ausgangstransistor der Darlington-Schaltung. Die Emittergebiete 4, 6 usw. bilden in ihrer Gesamtheit den Emitter des Treibertransistors, die Emittergebiete 5, 7 usw. in ihrer Gesamtheit den Emitter des Ausgangstransistors. Wie aus Fig. 1 hervorgeht, sind die Emittergebiete 4, 6 usw. mit den Emittergebieten 5, 7 usw. derart verschachtelt angeordnet, daß jedes Emittergebiet, z.B. 5, des Ausgangstransistors neben wenigstens einem Emittergebiet, z.B. 4, des Treibertransistors liegt.

Die Anordnung der Emittergebiete des Ausgangstransistors und des Treibertransistors ist in Fig. 1 so getroffen, daß zwischen zwei Emittergebieten, z.B. 5 und 7, des Ausgangstransistors jeweils ein Emittergebiet, z.B. 4, des Treibertransistors liegt, dessen leitende Belegung, z.B. 14, die Basisschicht 2 an einem Ort kontaktiert, der zwischen dem Emittergebiet, z.B. 4, des Treibertransistors und dem einen der beiden Emittergebiete, z.B. 5, des Ausgangstransistors liegt, während ein Basiskontakt, z.B. 8, zwischen dem betrachteten Emittergebiet des Treibertransistors und dem anderen der beiden Emittergebiete, z.B. 7, des Ausgangstransistors angeordnet ist.

Geht man vom nichtleitenden Zustand der Darlington- Schaltung aus, bei dem eine hohe Spannung von z.B. 1000 Volt zwischen den Anschlüssen 20 und 13 wirksam ist, wobei der Anschluß 20 auf einem positiveren Potential liegt als der auf Bezugspotential befindliche Anschluß 13, und führt über den Basisanschluß 10 einen positiven Basisstrom Ib zu, so gelangen positive Ladungsträger aus dem unterhalb des Basiskontakts liegenden Teil der Basisschicht 2 etwa in Richtung des Pfeiles 21 zu dem über die leitende Belegung 14 positiv vorgespannten pn-Übergang zwischen den Teilen 2 und 4. Das Emittergebiet 4 injiziert daraufhin negative Ladungsträger in die Basisschicht 2, wobei diese zusammen mit positiven Ladungsträgern, die durch den Basisstrom Ib eingeschwemmt werden, eine sog. Speicherladung bilden, die sich zunächst unterhalb von 4 in der Basisschicht 2 aufbaut und sich bei anhaltendem Basisstrom schließlich nach dem Abbau der Raumladungszone zwischen den Teilen 2·und 3a auch auf die Teilschicht 3a ausdehnt. Die seitlichen Grenzen der Speicherladung unterhalb von 4 werden durch die gestrichelten Linien 22 und 23 angedeutet. Es findet sowohl in vertikaler als auch in lateraler Richtung eine Aufweitung der eigentlichen Basiszone von T1 statt, wobei die Leitfähigkeit innerhalb dieser aufgeweiteten Basiszone wesentlich größer ist als der Grunddotierung der Schichten 2 und 3a entsprechen würde. Der hieraus resultierende Kollektorstrom Ic1 des Transistors T1 fließt über die Belegung 14 zu dem von ihr kontaktierten Teilgebiet der Basisschicht 2 im Bereich des Fensters 16. Damit gelangen positive Ladungsträger von diesem Ort längs des Pfeiles 24 zum pn- Übergang zwischen den Teilen 2 und 5. Als Folge davon injiziert das Emittergebiet 5 negative Ladungsträger, die zusammen mit den durch Ic1 eingeschwemmten positiven Ladungsträgern unterhalb von 5 eine Speicherladung aufbauen, die durch die seitlichen Begrenzungen 25 und 26 angedeutet wird. Wegen der durch diese Vorgänge vertikal und lateral aufgeweiteten Basiszone von T2, in der die Leitfähigkeit stark vergrößert ist, ergibt sich ein starker Kollektorstrom Ic2 für den Transistor T2.

Analoge Vorgänge laufen beim Einschalten des Basisstroms Ib auch im Bereich der weiteren Transistorkombinationen T3, T4 ... T(2n-1), Tn ab, wobei die Summe der Kollektorströme der Transistoren T2, T4, ... T2n den Kollektorstrom Ic des Ausgangstransistors der Darlington-Schaltung bildet.

Wenn sich die Speicherladungen innerhalb der einzelnen Transistorkombinationen, z.B. T1, T2, gegenseitig überlappen, wie das durch die Linien 22 bis 26 in Fig. 1 dargestellt ist, so wird durch den Aufbau der Speicherladungen von T1, T3 ... T(2n-1) gleichzeitig jeweils ein Teil der Speicherladungen von T2, T4 ... T2n mit aufgebaut. Das bedeutet aber, daß sich der restliche Aufbau der Speicherladung von T2, T4 ... T2n viel schneller vollzieht als das ohne diese Überlappung der Fall wäre. Es erfolgt also eine wesentliche Verringerung der Einschaltverzögerungszeit $t_d$. Dieser Effekt tritt bei Strukturen nach Fig. 1 auf, bei denen die Dicke d des Halbleiterkörpers 1 größer ist als der halbe laterale Abstand zweier benachbarter Emittergebiete, z.B. 5 und 7, des Ausgangstransistors, zwischen denen sich ein Emittergebiet, z.B. 4, des Treibertransistors befindet.

Nach einer bevorzugten Ausgestaltung der Erfindung wird die Breite b eines der Emittergebiete des Ausgangstransistors, z.B. 5, gemessen in Richtung auf das benachbarte Emittergebiet, z.B. 7, dieses Transistors, kleiner gewählt als der laterale Abstand zwischen diesen beiden Emittergebieten, z.B. 5 und 7, die zwischen sich ein Emittergebiet, z.B. 4, des Treibertransistors einschließen. In Fig. 1 beträgt b etwa 1/5 dieses lateralen Abstandes. Insbesondere bei Hochspannungstransistoren tritt eine so starke Auffächerung der Kollektorstrompfade der Transistoren T2, T4 ... T2n in lateraler Richtung auf, daß für eine vorgegebene Anzahl von n Transistorkombinationen eine sich aus der Verkleinerung von b ergebende Verringerung der Querschnittsfläche des Halbleiterkörpers 1 (gemessen in der Ebene der Grenzfläche 1a) ausgenutzt werden kann, ohne eine nennenswerte Verringerung des maximal zulässigen Kollektorstroms Ic der Darlington-Schaltung in Kauf nehmen zu müssen. Insbesondere kann die Breite b vorteilhafterweise ohne wesentliche Verringerung des maximal zulässigen Kollektorstroms Ic um etwa eine Größenordnung kleiner gewählt werden als der genannte laterale Abstand. Bei einem lateralen Abstand von z.B. 100 μm kann die Breite b z.B. auf 10 μm reduziert werden. Bei herkömmlichen Darlington-Schaltungen beträgt die Breite eines Emitters des Ausgangstransistors demgegenüber 100 bis 200 μm. Die Breite der Emittergebiete, z.B. 4, des Treibertransistors wird bei einer erfindungsgemäßen Ausbildung der Schaltung zweckmäßigerweise der Breite der Emittergebiete des Ausgangstransistors angeglichen.

Die sich überlappenden Speicherladungen innerhalb der einzelnen Transistorkombinationen T1, T2 .. T(2n-1), T2n führen auch beim Umkehren der Richtung des Basisstroms, d.h. beim Ausschalten der Darlington-Schaltung, zu einer wesentlichen Verkleinerung der Speicherzeit $t_s$, da beim Abbau der Speicherladung unterhalb eines Emittergebiets, z.B. 4, des Treibertransistors gleichzeitig ein Teil der Speicherladung des zur gleichen Kombination gehörenden Emittergebiets, z.B. 5, des Ausgangstransistors abgebaut wird. Damit ergibt sich eine größere Schaltgeschwindigkeit beim Ausschalten des Kollektorstroms Ic.

Fig. 2 zeigt ein zweites Ausführungsbeispiel der Erfindung, bei dem die Anordnung der Emittergebiete des Treibertransistors und des Ausgangstransistors abweichend von Fig. 1 getroffen ist. Die Transistoren T1 und T2 entsprechen dabei nach Aufbau und gegenseitiger Anordnung den gleichbezeichneten Transistoren von Fig. 1. Die Transistorkombination T3, T4 von Fig. 1 ist nun in Fig. 2 in seitenverkehrter Lage auf dem Halbleiterkörper 1 aufgebaut und mit T3a, T4a bezeichnet. Dabei werden der Basisanschluß 8 von T1 und der Basisanschluß 9 von T3 zu einem Basisanschluß 8a zusammengefaßt, der den Transistoren T1 und T3a gemeinsam ist. Eine weitere Transistorkombination T5a, T6a ist entsprechend der Kombination T1, T2 aufgebaut und derart neben dem Transistor T4a angeordnet, daß das zu T6a gehörige Emittergebiet des Ausgangstransistors und das zu T4a gehörige Emittergebiet des gleichen Transistors zu einem gemeinsamen Gebiet 4a zusammengefaßt sind. Damit sind in Fig. 2 zwischen jeweils zwei Emittergebieten des Ausgangstransistors, z.B. 5 und 4a, jeweils zwei Emittergebiete, z.B. 4 und 4b, des Treibertransistors angeordnet, wobei die leitende Belegung 14 des Emittergebietes 4 die Basisschicht 2 innerhalb eines Teilgebiets 27 kontaktiert, das zwischen den Gebieten 4 und 5 liegt, während die leitende Belegung 17a des Emittergebiets 4b des Treibertransistors die Basisschicht 2 im Bereich eines Teilgebiets 28 kontaktiert, das zwischen dem Emittergebiet 4b des Treibertransistors und dem Emittergebiet 4a des Ausgangstransistors liegt. Zwischen den Emittergebieten 4 und 4b ist der für T1 und T3a gemeinsame Basiskontakt 8a vorgesehen. Die Dicke d des Halbleiterkörpers ist wieder größer als der halbe laterale Abstand zweier benachbarter Emittergebiete, z.B. 4a und 5, des Ausgangstransistors.

Die sich unterhalb der beiden Emittergebiete, z.B. 4 und 5, einer jeden Transistorkombination, z.B. T1, T2, aus bildenden Speicherladungen überlappen sich in Fig. 2 analog zu Fig. 1, so daß das Schaltverhalten des Ausführungsbeispiels nach Fig. 2 etwa der Schaltung nach Fig. 1 entspricht. Die oben erläuterten Maßnahmen zur Reduzierung der Breite b der einzelnen Emittergebiete des Ausgangstransistors im Verhältnis zu dem lateralen Abstand zwischen zwei einander benachbarten Emittergebieten, z.B. 5 und 4a, desselben sind auch auf die Schaltung nach Fig. 2 anwendbar, wobei durch diese Maßnahmen erreicht wird, daß der in der Grenzfläche 1a gemessene Querschnitt des Halbleiterkörpers 1 bei einer vorgegebenen Anzahl n von Transistorkombinationen verringert wird. Die insgesamt erforderliche Querschnittsfläche ist wegen der Zusammenfassung jeweils zweier Emittergebiete des Ausgangstransistors zu einem Gebiet, z.B. 4a, und der Zusammenfassung jeweils zweier Basisanschlüsse zu einem, z.B. 8a, noch kleiner als bei der Schaltung nach Fig. 1.

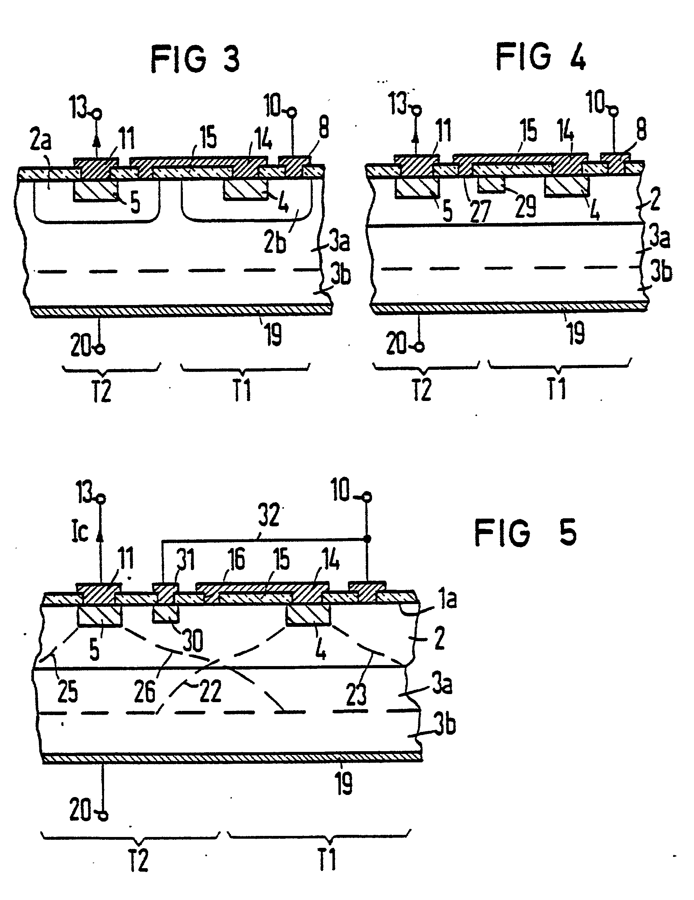

Nach einer in Fig. 3 dargestellten Weiterbildung der Erfindung ist die Basisschicht 2 nicht als eine allen Transistoren gemeinsame Schicht ausgeführt, sondern in einzelne inselförmige Gebiete 2a, 2b usw. aufgeteilt, die die Emittergebiete, z.B. 4 und 5, des Treibertransistors und des Ausgangstransistors jeweils einzeln umgeben. Die leitende Belegung eines Emittergebiets, z.B. 4, des Treibertransistors kontaktiert dabei jeweils das inselförmige Gebiet, z.B. 2a, das das benachbarte Emittergebiet, z.B. 5, des Ausgangstransistors umgibt. Hierdurch wird sichergestellt, daß die leitende Belegung 14 nicht als eine niederohmige Verbindung zwischen den Teilen 2b und 4 wirkt und als solche eine positive Vorspannung am pn-Übergang zwischen diesen Teilen beeinträchtigt. Bei einer gemäß Fig. 3 erreichbaren ausgeprägten positiven Vorspannung an diesem pn-Übergang wird der über den Basiskontakt 8 eingespeiste Basisstromanteil praktisch vollständig dem Emittergebiet 4 zugeführt, was eine hohe Stromverstärkung der Darlington- Schaltung gewährleistet.

Fig. 4 zeigt eine andere Weiterbildung der Erfindung, bei der die Basisschicht 2 als eine durchgehende, allen Transistoren gemeinsame Basisschicht bestehen bleibt und zwischen jedem Emittergebiet, z.B. 4, des Treibertransistors und dem Teilgebiet, z.B. 27, der Basisschicht 2, an dem die von diesem Emittergebiet ausgehende leitende Belegung 14 die Schicht 2 kontaktiert, jeweils ein n-leitendes Gebiet 29 eingefügt ist, das sich vorzugsweise bis zur Grenzfläche 1a erstreckt. Hierdurch wird ebenfalls verhindert, daß die leitende Belegung 14 eine so niederohmige Überbrückung des pn-Übergangs zwischen den Teilen 2 und 4 darstellt, daß sich an dem letzteren keine ausreichende positive Vorspannung einstellt. Auch bei der Weiterbildung nach Fig. 4 wird der über den Basisanschluß 8 eingespeiste Basisstromanteil praktisch vollständig dem Emittergebiet 4 zugeführt, so daß eine hohe Stromverstärkung der Darlington-Schaltung gewährleistet ist. Bei den Ausführungsbeispielen nach Fig. 1 und Fig. 2 ist es zur Erzielung einer hinreichend großen positiven Vorspannung an den pn-Übergängen der Teile 2 und 4, 2 und 6 usw. zweckmäßig, die leitenden Belegungen 14, 17 usw. so weit zu verlängern, daß die durch die letzteren kontaktierten Teilgebiete der Basisschicht 2 ein Potential aufweisen, das hinreichend negativ ist gegenüber dem Potential der Basisschicht 2 in der unmittelbaren Umgebung der Emittergebiete 4, 6 usw., von denen die leitenden Belegungen ausgehen.

In Fig. 5 ist eine besonders vorteilhafte Weiterbildung der Erfindung dargestellt, bei der in wenigstens eine, vorzugsweise jedoch in alle Transistorkombinationen, z. B. T1, T2, jeweils neben dem Emittergebiet, z.B. 5, des Ausgangstransistors ein $n^+$-dotiertes Halbleitergebiet 30 in die Basisschicht 2 eingefügt ist, das sich bis zur Grenzfläche 1a hin erstreckt. Jedes der Halbleitergebiete 30 ist mit einem Kontakt 31 versehen, der an den Basisanschluß 10 geschaltet ist. Ein solches Gebiet 30 bildet mit dem angrenzenden Teilgebiet der Basisschicht 2 eine Ausräum diode, die beim Anschalten einer negativen Spannung an den Basisanschluß 10, d.h. beim Ausschalten des Kollektorstromes Ic, leitend geschaltet wird und einen beschleunigten Abbau der Speicherladungen, z.B. 22, 23 und 25, 26, bewirkt. Damit wird die Speicherzeit $t_s$ weiter herabgesetzt.

Eine in dieser Weise integrierte Ausräumdiode 2, 30, 31 ersetzt eine in herkömmlichen Schaltungen verwendete, externe Ausräumdiode, die zwischen die Basis des Treibertransistors und die Basis des Ausgangstransistors geschaltet ist. Dabei hat die integrierte Ausräumelektrode 2, 30, 31 den wesentlichen Vorteil, daß für ihren Anschluß nur ein Kontakt 31 und eine Verbindung, z.B. eine Leiterbahn 32, zum Basisanschluß 10 benötigt werden, wogegen eine externe Ausräumdiode zwei Anschlußleitungen erfordert und den Raumbedarf der Darlington-Schaltung wesentlich stärker erhöht.

Eine besondere Wirksamkeit der Ausräumdiode 2, 30, 31 ergibt sich dann, wenn sie in den einzelnen Transistorkombinationen jeweils zwischen dem Emittergebiet, z.B. 5, und dem Teilgebiet der Basisschicht (z.B. unterhalb des Fensters 16) angeordnet wird, das von der leitenden Belegung, z.B. 14, des zugeordneten Emittergebiets, z.B. 4, des Treibertransistors kontaktiert wird. Je größer die Anzahl der Transistorkombinationen, z.B. T1, T2, ist, die mit einer Ausräumdiode 2, 30, 31 ausgestattet sind, desto kleiner wird die Speicherzeit $t_s$, da um so mehr Transistorkombinationen gleichzeitig von ihren Speicherladungen befreit werden.

Die Integration von Ausräumdioden 2, 30, 31 ist bei jeder der dargestellten und beschriebenen Ausführungsformen der Erfindung zweckmäßig, auch wenn diese gemäß den Figuren 3 oder 4 ausgebildet sind. Mit besonderem Vorteil werden die Ausräumdioden in solche Ausführungsformen der Erfindung integriert, bei denen die Breite b der Emittergebiete des Ausgangstransistors wesentlich kleiner gewählt ist als der laterale Abstand zwischen zwei solchen Gebieten, z.B. 5 und 7 oder 5 und 4a. Dabei kann b um etwa eine Größenordnung kleiner bemessen sein als dieser Abstand.

Neben den bisher beschriebenen Ausführungsformen der Erfindung sind auch solche von Interesse, bei denen die bisher genannten Halbleitergebiete jeweils durch solche des entgegengesetzten Leitfähigkeitstyps ersetzt sind, wobei anstelle der bisher genannten Spannungen bzw. Ströme solche des jeweils entgegengesetzten Vorzeichens verwendet werden.

**Patentansprüche**

1. Monolithisch integrierte bipolare Darlington-Schaltung mit einem Treibertransistor und einem Ausgangstransistor, bei der ein Halbleiterkörper (1) eine Basisschicht (2) eines ersten Leitfähigkeitstyps und eine Kollektorschicht (3) eines zweiten Leitfähigkeitstyps enthält, bei der der Treibertransistor und der Ausgangstransistor jeweils Emitter des zweiten Leitfähigkeitstyps aufweisen, die in die Basisschicht (2) eingefügt sind, bei der der Emitter des Treibertransistors mit einem zwischen beiden Transistoren liegenden Teilgebiet der Basisschicht leitend verbunden ist, und bei der die Basisschicht, der Emitter des Ausgangstransistors und die Kollektorschicht jeweils mit einem Basisanschluß (10), einem Emitteranschluß (13) und einem Kollektoranschluß (20) versehen sind, **dadurch gekennzeichnet, daß** der Emitter des Ausgangstransistors aus einer Mehrzahl von Emittergebieten (5, 7) besteht, die mit an den Emitteranschluß (13) gelegten Emitterkontakten (11, 12) versehen sind, daß der Emitter des Treibertransistors aus einer Mehrzahl von Emittergebieten (4, 6) besteht, die jeweils derart zwischen den Emittergebieten (5, 7) des Ausgangstransistors angeordnet sind, daß jedes Emittergebiet (5) des Ausgangstransistors neben wenigstens einem Emittergebiet (4) des Treibertransistors liegt, wobei jedes Emittergebiet des Treibertransistors mit einer leitenden Belegung (14) versehen ist, die die Basisschicht (2) zwischen ihm und dem benachbarten Emittergebiet (5) des Ausgangstransistors kontaktiert, daß der Basisanschluß (10) mit einer Mehrzahl von Basiskontakten (8, 9) verbunden ist, die auf der Basisschicht (2) jeweils zu den Emittergebieten (4, 6) des Treibertransistors benachbart angeordnet sind, und daß die Dicke (d) des Halbleiterkörpers (1) größer ist als der halbe laterale Abstand zweier einander benachbarter Emittergebiete (5, 7) des Ausgangstransistors, zwischen denen sich wenigstens ein Emittergebiet (4) des Treibertransistors befindet.

2. Monolithisch integrierte bipolare Darlington-Schaltung nach Anspruch 1, **dadurch gekennzeichnet, daß** die Breite (b) eines Emittergebietes (5) des Ausgangstransistors, gemessen in Richtung auf ein benachbartes Emittergebiet (7) dieses Transistors, kleiner ist als der laterale Abstand zwischen diesen beiden Emittergebieten (5, 7).

3. Monolithisch integrierte bipolare Darlington-Schaltung nach Anspruch 2, **dadurh gekennzeichnet, daß** die Breite (b) eines Emittergebietes (5) des Ausgangstransistors, gemessen in Richtung auf ein benachbartes Emittergebiet (7) dieses Transistors, um eine Größenordnung kleiner ist als der laterale Abstand zwischen diesen beiden Emittergebieten (5, 7).

4. Monolithisch integrierte bipolare Darlington-Schaltung nach einem der Ansprüche 2 oder 3, **dadurch gekennzeichnet, daß** zwischen jeweils zwei Emittergebieten (5, 7) des Ausgangstransistors ein Emittergebiet (4) des Treibertransistors angeordnet ist, dessen leitende Belegung (14) die Basisschicht (2) an einem Ort kontaktiert, der zwischen dem Emittergebiet (4) des Treibertransistors und dem ersten (5) der beiden Emittergebiete des Ausgangstransistors liegt, und daß ein Basiskontakt (8) zwischen dem Emittergebiet (4) des Treibertransistors und dem zweiten (7) der beiden Emittergebiete des Ausgangstransistors angeordnet ist.

5. Monolithisch integrierte bipolare Darlington-Schaltung nach einem der Ansprüche 2 oder 3, **dadurch gekennzeichnet, daß** zwischen jeweils zwei Emittergebieten (5, 4a) des Ausgangstransistors jeweils zwei Emittergebiete (4, 4b) des Treibertransistors angeordnet sind, daß die leitende Belegung des ersten (4) der beiden Emittergebiete des Treibertransistors die Basisschicht (2) an einem Ort (27) kontaktiert, der zwischen ihm und dem ersten (5) der beiden Emittergebiete des Ausgangstransistors liegt, daß die leitende Belegung (17a) des zweiten Emittergebiets (4b) des Treibertransistors die Basisschicht (2) an einem Ort (28) kontaktiert, der zwischen diesem zweiten Emittergebiet des Treibertransistors und dem zweiten (4a) der beiden Emittergebiete des Ausgangstransistors liegt, und daß ein Basiskontakt (8a) zwischen den beiden Emittergebieten (4, 4b) des Treibertransistors angeordnet ist.

6. Monolithisch integrierte bipolare Darlington-Schaltung nach einem der Ansprüche 1 bis 5, **dadurch gekennzeichnet,** daß die Basisschicht in eine Mehrzahl von inselförmigen Gebieten (2a, 2b) aufgeteilt ist, die die Emittergebiete (5, 4) des Ausgangstransistors und des Treibertransistors jeweils einzeln umgeben, und daß die leitende Belegung (14) eines Emittergebiets (4) des Treibertransistors jeweils das das benachbarte Emittergebiet (5) des Ausgangstransistors umgebende inselförmige Gebiet (2a) der Basisschicht kontaktiert.

7. Monolithisch integrierte bipolare Darlington-Schaltung nach einem der Ansprüche 1 bis 5, **dadurch gekennzeichnet,** daß eine inselförmige Zone (29) des zweiten Leitfähigkeitstyps jeweils zwischen einem Emittergebiet (4) des Treibertransistors und dem Ort (27), an dem die leitende Belegung (14) dieses Emittergebiets die Basisschicht (2) kontaktiert, in die Basisschicht (2) eingefügt ist.

8. Monolithisch integrierte bipolare Darlington-Schaltung nach einem der vorhergehenden Ansprüche, **dadurch gekennzeichnet,** daß die Kollektorschicht (3) aus einer unterhalb der Basisschicht (2) liegenden schwach dotierten Teilschicht (3a) des zweiten Leitfähigkeitstyps und aus einer unterhalb derselben liegenden stark dotierten Teilschicht (3b) des gleichen Leitfähigkeitstyps besteht.

9. Monolithisch integrierte bipolare Darlington-Schaltung nach einem der vorhergehenden Ansprüche, **dadurch gekennzeichnet,** daß neben wenigstens einem, vorzugsweise aber neben allen, Emittergebieten (5) des Ausgangstransistors jeweils ein inselförmiges Halbleitergebiet (30) des zweiten Leitfähigkeitstyps in die Basisschicht (2) eingefügt ist, das sich bis zur Grenzfläche (1a) des Halbleiterkörpers (1) erstreckt und einen Kontakt (31) aufweist, der mit dem Basisanschluß (10) verbunden ist.

10. Monolithisch integrierte bipolare Darlington-Schaltung nach Anspruch 9, **dadurch gekennzeichnet** daß das inselförmige Halbleitergebiet (30) derart neben dem Emittergebiet (5) des Ausgangstransistors angeordnet ist, daß es zwischen diesem und dem Ort liegt, an dem eine leitende Belegung (14) eines benachbarten Emittergebiets (4) des Treibertransistors die Basisschicht (2) kontaktiert.

## Claims

1. Monolithic integrated bipolar Darlington circuit having a drive transistor and an output transistor, in which circuit a semiconductor body (1) contains a base layer (2) of a first conductivity type and a collector junction (3) of a second conductivity type, in which circuit the drive transistor and the output transistor in each have case have emitters of the second conductivity type, which are inserted into the base layer (2), in which circuit the emitter of the drive transistor is conductively connected to a subregion lying between the two transistors, and in which circuit the base layer, the emitter of the output transistor and the collector junction are provided in each case with a base terminal (10), and emitter terminal (13) and a collector terminal (20), characterized in that the emitter of the output transistor consists of a plurality of emitter regions (5, 7), which are provided with emitter contacts (11, 12) connected to the emitter terminal (13), in that the emitter of the drive transistor consists of a plurality of emitter regions (4, 6), which are arranged in each case between the emitter regions (5, 7) of the output transistor in such a way that each emitter region (5) of the output transistor lies next to at least one emitter region (4) of the drive transistor, each emitter region of the drive transistor being provided with a conductive coating (14), which contacts the base layer (2) between it and the adjacent emitter region (5) of the output transistor, in that the base terminal (10) is connected to a plurality of base contacts (8, 9), which are arranged on the base layer (2) adjacent, in each case, to the emitter regions (4, 6) of the drive transistor, and in that the thickness (d) of the semiconductor body (1) is larger than half the lateral separation of tow adjacent emitter regions (5, 7) of the output transistor, between which there is located at least one emitter region (4) of the drive transistor.

2. Monolithic integrated bipolar Darlington circuit according to Claim 1, characterized in that the width (b) of an emitter region (5) of the output transistor, measured in the direction towards an adjacent emitter region (7) of this transistor, is smaller than the lateral separation between these two emitter regions (5, 7).

3. Monolithic integrated bipolar Darlington circuit according to Claim 2, characterized in that the width (b) of an emitter region (5) of the output transistor, measured in the direction towards an adjacent emitter region (7) of this transistor, is smaller by one order of magnitude then the lateral separation between these two emitter regions (5, 7).

4. Monolithic integrated bipolar Darlington circuit according to one of Claims 2 or 3, characterized in that there is arranged in each case between two emitter regions (5, 7) of the output transistor an emitter region (4) of the drive transistor the conductive coating (14) of which emitter region contacts the base layer (2) at a location which lies between the emitter region (4) of the drive transistor and the first (5) of the two emitter regions of the output transistor, and in that a base contact (8) is arranged between the emitter region (4) of the drive transistor and the second (7) of the two emitter regions of the output transistor.

5. Monolithic integrated bipolar Darlington circuit according to one of Claims 2 or 3, characterized in that in each case two emitter regions (4, 4b) of the drive transistor are arranged between in each case two emitter regions (5, 4a) of the output transistor, in that the conductive coating of the first (4) of the two emitter regions of the drive transistor contact the base layer (2) at a location (27) which lies between it and the first (5) of the two emitter regions of the output transistor, in that the conductive coating (17a) of the second emitter region (4b) of the drive transistor contacts the base layer (2) at a location (28) which lies between this second emitter region of the drive transistor and the second (4a) of the two emitter regions of the output transistor and, in that a base contact (8a) is arranged between the two emitter regions (4, 4b) of the drive transistor.

6. Monolithic integrated bipolar Darlington circuit according to one of Claims 1 to 5, characterized in that the base layer is subdivided into a plurality of insular regions (2a, 2b), which in each case individually surround the emitter regions (5, 4) of the output transistor and of the drive transistor, and in that the conductive coating (14) of an emitter region (4) of the drive transistor in each contacts the insular region (2a) of the base layer surrounding the adjacent emitter region (5) of the output transistor.

7. Monolithic integrated bipolar Darlington circuit according to one of Claims 1 to 5, characterized in that an insular zone (29) of the second conductivity type is inserted in each case into the base layer (2) between an emitter region (4) of the drive transistor and the location (27) at which the conductive coating (14) of this emitter region contacts the base layer (2).

8. Monolithic integrated bipolar Darlington circuit according to one of the preceding claims, characterized in that the collector junction (3) consists of a weakly doped sublayer (3a) of the second conductivity type lying below the base layer (2), and of a strongly doped sublayer (3b) of the same conductivity type lying below said sublayer.

9. Monolithic integrated bipolar Darlington circuit according to one of the preceding claims, characterized in that in each case there is inserted into the base layer (2) next to at least one, but preferably next to all emitter regions (5) of the output transistor an insular semiconductor region (30) of the second conductivity type which extends up to the boundary surface (1a) of the semiconductor body (1), and has a contact (31) which is connected to the base terminal (10).

10. Monolithic integrated bipolar Darlington circuit according to Claim 9, characterized in that the insular semiconductor region (30) is arranged next to the emitter region (5) of the output transistor in such a way that it lies between the latter and the location at which a conductive coating (14) of an adjacent emitter region (4) of the drive transistor contacts the base layer (2).

**Revendications**

1. Circuit de Darlington bipolaire et à intégration monolithique du type comprenant un transistor d'attaque et un transistor de sortie, dans lequel un corps semiconducteur (1) comporte une couche de base (2) d'un premier type de conductibilité et une couche de collecteur (3) d'un second type de conductibilité, dans lequel le transistor d'attaque et le transistor de sortie comportent, respectivement, un émetteur du second type de conductibilité qui est inséré dans la couche de base (2), dans lequel l'émetteur du transistor d'attaque est relié à conduction à une zone partielle de la couche de base, qui est située entre les deux transistors, et dans lequel la couche de base, l'émetteur du transistor de sortie et la couche de collecteur sont respectivement pourvus d'une borne de base (10), d'une borne d'émetteur (13) et d'une borne de collecteur (20), caractérisé par le fait que l'émetteur du transistor de sortie est constitué par plusieurs zones d'émetteurs (5, 7) qui sont pourvues de contacts d'émetteur (11, 12) reliés à la borne d'émetteur (13), que l'émetteur du transistor d'attaque est constitué par plusieurs zones d'émetteurs (4, 6) qui sont disposées, respectivement, de telle façon entre les zones d'émetteurs (5, 7) du transistor de sortie, que chaque zone d'émetteur (5) du transistor de sortie est située près d'au moins une zone d'émetteur (4) du transistor d'attaque, chaque zone d'émetteur du transistor d'attaque étant pourvue d'un revêtement conducteur (4) qui contacte la couche de base (2) entre ledit transistor d'attaque et la zone d'émetteur voisine (5) du transistor de sortie, que la borne de base (10) est reliée à une pluralité de contacts de base (8, 9) qui sont disposés, sur la couche de base (2), respectivement dans le voisinage des zones d'émetteur (4, 6) du transistor d'attaque et que l'épaisseur (d) du corps semiconducteur (1) est supérieure à la demi-distance latérale entre deux zones d'émetteurs voisines (5, 7) du transistor de sortie, entre lesquelles se situe au moins une zone d'émetteurs (4) du transistor d'attaque.

2. Circuit de Darlington bipolaire et à intégration monolithique selon la revendication 1, caractérisé par le fait que la largeur (b) d'une zone d'émetteur (5) du transistor de sortie, mesurée en direction d'une zone d'émetteur voisine (7) de ce transistor, est inférieure à la distance latérale entre ces deux zones d'émetteurs (5, 7).

3. Circuit de Darlington bipolaire et à intégration monolithique selon la revendication 2, caractérisé par le fait que la largeur (b) d'une zone d'émetteur (5) du transistor de sortie, mesurée en direction d'une zone d'émetteur voisine (7) de ce transistor, est inférieure, d'un ordre de grandeur, à la distance latérale entre ces deux zones d'émetteurs (5, 7).

4. Circuit de Darlington bipolaire et à intégration monolithique selon l'une des revendications 2 ou 3, caractérisé par le fait qu'entre respectivement deux zones d'émetteurs (5, 7) du transistor de sortie, est prévue une zone d'émetteur (4) du transistor d'attaque, dont le revêtement conducteur (14) contacte la couche de base (2) en un emplacement qui se situe entre la zone d'émetteur (4) du transistor d'attaque et la première (5) des deux zones d'émetteurs du transistor de sortie, et que le contact de base (8) entre la zone d'émetteur (4) du transistor d'attaque et la seconde (7) des deux zones d'émetteur du transistor de sortie.

5. Circuit de Darlington bipolaire et à intégration monolithique selon l'une des revendications 2 ou 3, caractérisé par le fait qu'entre respectivement deux zones d'émetteurs (5, 4a) du transistor de sortie, sont disposées, respectivement, deux zones d'émetteurs (4, 4b) du transistor d'attaque, que le revêtement conducteur de la première (4) des deux zones d'émetteur du transistor d'attaque contacte la couche de base (2) en un emplacement (27) qui se situe entre lui et la première zone (5) des deux zones d'émetteurs du transistor de sortie, que le revêtement conducteur (17a) de la seconde zone d'émetteur (4b) du transistor d'attaque contacte la couche de base (2) en un emplacement (28) qui se situe entre cette seconde zone d'émetteur du transistor d'attaque et la seconde (4a) des deux zones d'émetteurs du transistor de sortie, et qu'un contact de base (8a) est disposé entre les deux zones d'émetteur (4, 4b) du transistor d'attaque.

6. Circuit de Darlington bipolaire et à intégration monolithique selon les revendications 1 à 5, caractérisé par le fait que la couche de base est subdivisée en une pluralité de zones en forme d'îlots (2a, 2b) qui entourent respectivement et individuellement les zones d'émetteurs (5, 4) du transistor de sortie et du transistor d'attaque, et que le revêtement conducteur (14) d'une zone d'émetteur (4) du transistor d'attaque contacte la zone en forme d'îlot (2a) de la couche de base, qui entoure la zone d'émetteur voisine (5) du transistor de sortie.

7. Circuit de Darlington bipolaire et à intégration monolithique selon les revendications 1 à 5, caractérisé par le fait qu'une zone en forme d'îlot (29) du second type de conductibilité est insérée dans la couche de base (2), entre une zone d'émetteur (4) du transistor d'attaque et l'emplacement (27) au niveau duquel le revêtement conducteur (14) contacte cette zone d'émetteur de la couche de base (2).

8. Circuit de Darlington bipolaire et à intégration monolithique selon l'une des revendications précédentes, caractérisé par le fait que la couche de collecteur (3) est constituée par une couche partielle (3a) faiblement dopée et du second type de conductibilité, et située en-dessous de la couche de base (2), et par une couche partielle (3b) du même type de conductibilité mais fortement dopée et située en dessous de cette couche de collecteur (3).

9. Circuit de Darlington bipolaire et à intégration monolithique selon l'une des revendications précédentes, caractérisé par le fait qu'à côté d'au moins, mais de préférence à côté de toutes les zones d'émetteurs (5) du transistor de sortie, est insérée, dans la couche de base (2), respectivement une zone semiconductrice (30) de la forme d'un îlot et du second type de conductibilité, laquelle zone semiconductrice s'étend jusqu'à la surface limite du corps semiconducteur (1) et comporte un contact (31) qui est relié à la borne de base (10).

10. Circuit de Darlington bipolaire et à intégration monolithique selon la revendication 9, caractérisé par le fait que la zone semiconductrice de la forme d'un îlot (3) est disposé de telle façon près de la zone d'émetteur (5) du transistor de sortie, qu'elle se situe entre celle-ci et l'emplacement au niveau duquel un revêtement conducteur (14) d'une zone d'émetteur voisine (4) du transistor d'attaque, contacte la couche de base (2).

EP 0 176 762 B1

FIG 1

FIG 2

FIG 3

FIG 4

FIG 5